# EUROPEAN PATENT APPLICATION

(11) **EP 3 748 689 A1**
(43) Date of publication of application: **09.12.2020**
(21) Application number: 19178593.0
(22) Date of filing: 06.06.2019
(51) Int. Cl.: H01L 29/808, H01L 29/06, H01L 21/337, H01L 27/085, H01L 27/07, H01L 29/08, H01L 29/10

(54) **SEMICONDUCTOR DEVICE AND METHOD OF PRODUCING THE SAME**

(71) Applicant: Infineon Technologies Dresden GmbH & Co . KG, 01099 Dresden (DE)
(72) Inventor: WEIS, Rolf, 01109 Dresden (DE); KNOEFLER, Roman, 01109 Dresden (DE)
(74) Representative: Westphal, Mussgnug & Partner Patentanwälte mbB

(57) **Abstract**

A semiconductor device comprises a layer stack with a plurality of first semiconductor layers of a first doping type and a plurality of second semiconductor layers of a second doping type complementary to the first doping type, wherein the first semiconductor layers and the second semiconductor layers are arranged alternatingly between a first surface and a second surface of the layer stack. The semiconductor device further comprises a first semiconductor region of a first semiconductor device adjoining the plurality of first semiconductor layers, at least one second semiconductor region of the first semiconductor device, wherein each of the at least one second semiconductor region adjoins at least one of the plurality of second semiconductor layers, and is spaced apart from the first semiconductor region, and at least one barrier layer configured to form a diffusion barrier, wherein each of the at least one barrier layer is arranged in parallel to the first surface and to the second surface and adjacent to one of the first semiconductor layers, or adjacent to one of the second semiconductor layers, or both.

## Description

This disclosure in general relates to a semiconductor device, in particular a semiconductor device with a diode arrangement or a transistor arrangement.

Usually, transistor arrangements include a plurality of transistor devices formed in a semiconductor body. A superjunction transistor device, for example, usually includes at least one drift region of a first doping type (conductivity type) and a compensation region of a second doping type (conductivity type) complementary to the first doping type. The drift region and the compensation region are connected such that in an on-state (switched on state) of the transistor device a current can flow in the drift region, while in the off-state (switched off state) a depletion region expands in the drift region and the compensation region that prevents a current flow through the drift region. A transistor arrangement including a plurality of superjunction transistor devices, therefore, includes a plurality of drift regions and compensation regions. The drift regions and compensation regions of a transistor arrangement may be implemented as a layer stack with a plurality of first semiconductor layers of the first doping type and a plurality of second semiconductor layers of the second doping type.

Semiconductor layers of a first or a second doping type may be formed by forming an implantation region of a first type or of a second type in a layer of semiconductor material, followed by a subsequent diffusion process. Generally, it is desirable that after diffusion a number of dopant atoms in such a semiconductor layer is as high as possible. If a distance between an implantation region of the first type and an implantation region of the second type is small, interdiffusion may occur during the diffusion process. That is, a transition between the semiconductor layers of the first type and the semiconductor layers of the second type may not be sharp, which may adversely affect the functionality of the semiconductor device. The functionality of the semiconductor device, in particular the conductivity, may also be negatively affected by impurity interstitials close to the outer surfaces of a layer stack.

It is desirable to provide a semiconductor device that has a high conductivity and is more robust to impurity interstitials, and to provide a fast and cost effective method for producing the same.

### SUMMARY

One example relates to a semiconductor device including a layer stack with a plurality of first semiconductor layers of a first doping type and a plurality of second semiconductor layers of a second doping type complementary to the first doping type, wherein the first semiconductor layers and the second semiconductor layers are arranged alternatingly between a first surface and a second surface of the layer stack. The semiconductor device further includes a first semiconductor region of a first semiconductor device adjoining the plurality of first semiconductor layers, at least one second semiconductor region of the first semiconductor device, wherein each of the at least one second semiconductor region adjoins at least one of the plurality of second semiconductor layers, and is spaced apart from the first semiconductor region, and at least one barrier layer configured to form a diffusion barrier, wherein each of the at least one barrier layer is arranged in parallel to the first surface and to the second surface and adjacent to one of the first semiconductor layers, or adjacent to one of the second semiconductor layers, or both.

Another example relates to a method for producing a semiconductor device. The method includes forming a layer stack with a plurality of first layers of a first doping type, a plurality of second layers of a second doping type complementary to the first doping type, and at least one barrier layer that is configured to form a diffusion barrier, wherein each of the at least one barrier layer is arranged in parallel to the first surface and the second surface and adjacent to one of the first semiconductor layers, or adjacent to one of the second semiconductor layers, or both. The method further includes forming a first semiconductor region such that the first semiconductor region adjoins the plurality of first semiconductor layers, and forming at least one second semiconductor region such that each of the at least one second semiconductor region adjoins at least one of the plurality of second semiconductor layers, and is spaced apart from the first semiconductor region.

Examples are explained below with reference to the drawings. The drawings serve to illustrate certain principles, so that only aspects necessary for understanding these principles are illustrated. The drawings are not to scale. In the drawings the same reference characters denote like features.
Figures 1A - 1C schematically illustrate a perspective sectional view (Figure 1A), a vertical cross sectional view (Figure 1B), and a horizontal cross sectional view (Figure 1C of a transistor arrangement that includes a first transistor device and a second transistor device integrated in one semiconductor body;
Figures 2A - 2D show equivalent circuit diagrams that illustrate how the first transistor device and the second transistor device in a transistor arrangement of the type shown in Figures 1A - 1C may be connected;
Figures 3A - 3B illustrate one example of the second transistor device;
Figures 4, 5 and 6A-6B illustrate further examples of the second transistor device;
Figure 7 shows a vertical cross sectional view of a transistor arrangement according to one example;
Figure 8 shows a vertical cross sectional view of a transistor arrangement according to another example;
Figure 9 shows a vertical cross sectional view of a transistor arrangement according to another example;
Figure 10 illustrates an ideal doping profile;
Figure 11 illustrates a real doping profile of a conventional semiconductor arrangement;
Figure 12 illustrates a real doping profile of an exemplary semiconductor arrangement;
Figures 13A - 13F illustrate an example of a method for forming a transistor arrangement;
Figures 14A - 14F illustrate another example of a method for forming a transistor arrangement; and
Figures 15A - 15F illustrate another example of a method for forming a transistor arrangement.

In the following detailed description, reference is made to the accompanying drawings. The drawings form a part of the description and by way of illustration show specific embodiments in which the invention may be practiced. It is to be understood that the features of the various embodiments described herein may be combined with each other, unless specifically noted otherwise.

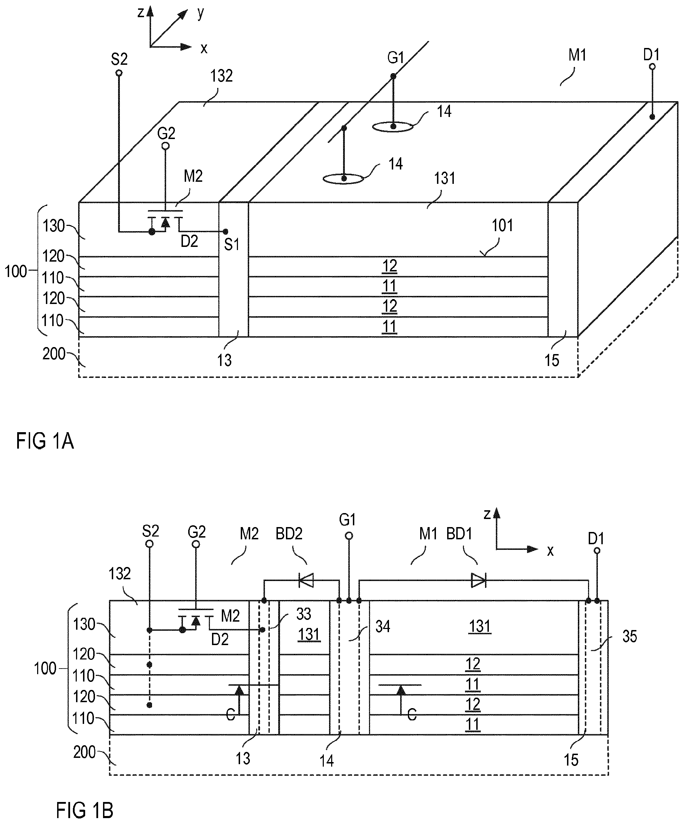

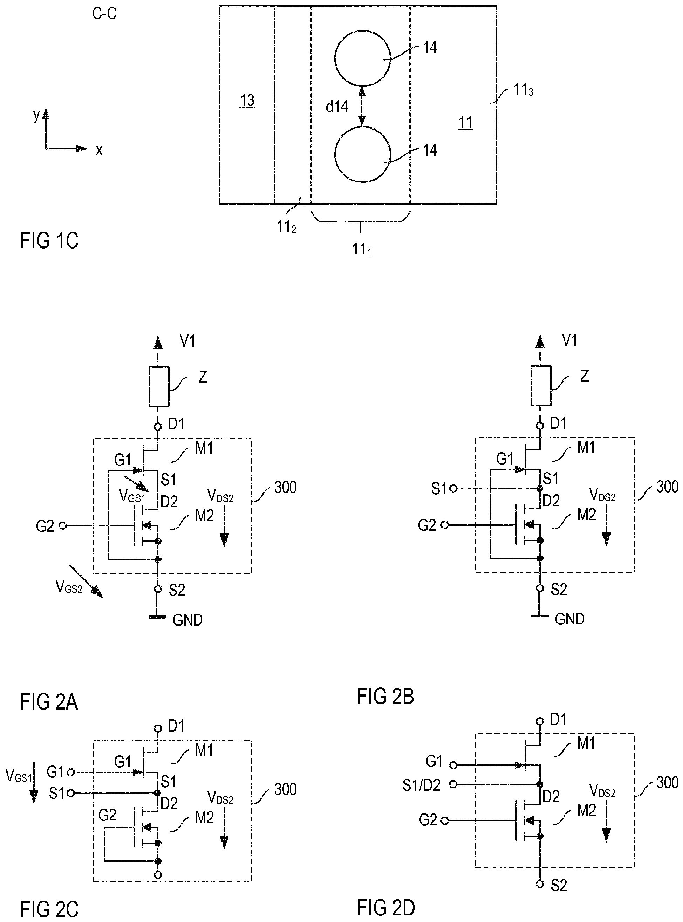

Figures 1A to 1C show a perspective sectional view (Figure 1A), a vertical cross sectional view (Figure 1B), and a horizontal cross sectional view (Figure 1C) of a semiconductor arrangement that includes a first semiconductor device M1 and a second semiconductor device M2. The first semiconductor device M1 and the second semiconductor device M2 are implemented as transistor devices in Figures 1A to 1C. The semiconductor arrangement includes a layer stack with a plurality of first semiconductor layers 110 of a first doping type and a plurality of second semiconductor layers 120 of a second doping type that are arranged alternatingly. The second doping type is complementary to the first doping type. A source region 13 of the first transistor device M1 adjoins the plurality of first semiconductor layers 110, and a drain region 15 of the first transistor device M1 adjoins the plurality of first semiconductor layers 110 and is located spaced apart from the source region 13 in a first direction x (horizontal direction). The source region 13 of the first transistor device M1 is also referred to as first source region or third semiconductor region 13 in the following, and the drain region 15 of the first transistor device M1 is also referred to as first drain region or first semiconductor region 15 in the following. The semiconductor arrangement further includes a plurality of gate regions 14 of the first transistor device M1. Each of the plurality of gate regions 14 adjoins at least one of the plurality of second semiconductor layers 120, is arranged between the first source region 13 and the first drain region 15, and is spaced apart from the first source region 13 and the first drain region 15.

As used herein, a layer or region of the first doping type is a layer or region with an effective doping of the first doping type. Such region or layer of the first doping type, besides dopants of the first doping type, may also include dopants of the second doping type, but the dopants of the first doping type prevail. Equivalently, a layer or region of the second doping type is a layer or region with an effective doping of the second doping type and may contain dopants of the first doping type.

Referring to Figures 1A to 1C, the semiconductor arrangement further includes a third semiconductor layer 130 that adjoins the layer stack with the first layers 110 and the second layers 120 and each of the first source region 13, the first drain region 15, and the gate regions 14. Active regions of the second transistor device M2 are integrated in the third semiconductor layer 130 in a second region 132. The second region 132 is spaced apart from a first region 131 of the third semiconductor layer 130, wherein the first region 131 is bordered by the first source region 13 and the first drain region 15. At least the first region 131 may be a region of the second doping type. The second transistor device M2 is only schematically illustrated in Figures 1A and 1B and represented by a circuit symbol.

The third semiconductor layer 130 and the layer stack with the first and second semiconductor layers 110, 120 form an overall layer stack 100, which is also referred to as semiconductor body 100 in the following. The semiconductor body 100 may include a conventional semiconductor material such as, for example, silicon (Si), silicon carbide (SiC), gallium nitride (GaN), gallium arsenide (GaAs), or the like. The semiconductor body 100 may be arranged on any kind of carrier 200 (illustrated in dashed lines in Figures 1A and 1B).

According to one example, the overall number of first layers 110 in the layer stack equals the overall number of second layers 120. In the example shown in Figures 1A and 1B, an uppermost layer of the layer stack is a second layer 120 and a lowermost layer is a first layer 110. The "uppermost layer" is the layer adjoining the third layer 130, and the lowermost layer is the layer spaced apart from the uppermost layer most distantly. However, implementing the uppermost layer as a second layer 120 and the lowermost layer as a first layer 110 is only an example. According to another example, not shown, the uppermost layer is a first layer 110 and the lowermost layer is a second layer 120. Just for the purpose of illustration, the layer stack with the first and second layers 110, 120 includes two first layers 110 and two second layers 120, that is, four layers overall. This, however, is only an example. According to one example, the overall number of layers 110, 120 in the layer stack is between 4 and 60, in particular between 6 and 30.

The first direction x, which is the direction in which the first source region 13 and the first drain region 15 are spaced apart from each other, is a first lateral direction of the semiconductor body 100 in the example shown in Figures 1A to 1C. A "lateral direction" of the semiconductor body 100 is a direction parallel to a first surface 101 of the semiconductor body 100. The first and second layers 110, 120 and the third layer 130 are essentially parallel to the first surface 101 in the example shown in Figures 1A to 1C. In this example, each of the first source region 13 and the first drain region 15 extend in a vertical direction z in the semiconductor body 100 so that each of the first source region 13 and the first drain region 15 adjoins the third layer 130 and the first layers 110. The "vertical direction" z is a direction perpendicular to the first surface 101. Further, the gate regions 14 extend in the vertical direction z in the semiconductor body 100 so that each of the plurality of gate regions 14 adjoins each of the second semiconductor layers 120. The gate regions 14 are spaced apart from each other in a second lateral direction y. This second lateral direction y is different from the first lateral direction x and may be perpendicular to the first lateral direction x.

The first transistor device M1 is a lateral superjunction depletion device, more specifically, a lateral superjunction JFET (Junction Field-Effect Transistor). In this transistor device M1, each of the first source region 13 and the first drain region 15 is a region of the first doping type and each of the gate regions 14 is a region of the second doping type. Further, in the section of the semiconductor body 100 between the first source region 13 and the first drain region 15, the first semiconductor layers 110 form drift regions 11 and the second semiconductor layers 120 form compensation regions 12 of the superjunction device. The function of these drift and compensation regions is explained herein further below.

A type of this first transistor device M1 is defined by the first doping type. The first transistor device M1 is an n-type JFET when the first doping type is an n-type and the second doping type is a p-type. Equivalently, the first transistor device M1 is a p-type JFET when the first doping type is a p-type and the second doping type is an n-type.

According to one example, the first source region 13, the drain region 15, the plurality of gate regions 14, the first and second layers 110, 120 forming the drift and compensation regions 11, 12, and the third layer 130 are monocrystalline semiconductor regions. According to one example, these regions include monocrystalline silicon (Si) and a doping concentration of the first source region 13 is selected from a range of between 1E17 cm⁻³ (=1·10¹⁷cm⁻³) and 1E21 cm⁻³, a doping concentration of the drift regions 11 is selected from a range of between 1E13 cm⁻³ and 1E18 cm⁻³, or between 1E14cm⁻³ and 5E17 cm⁻³, and a doping concentration of the gate regions 14 is selected from a range of between 1E17 cm⁻³ and 1E21 cm⁻³. The doping concentration of the first drain region 15 can be selected from the same range as the doping concentration of the first source region 13, and the doping concentration of the compensation regions 12 can be selected from the same range as the doping concentration of the drift regions 11.

Referring to Figures 1A and 1B, the gate regions 14 of the first transistor device M1 are connected to a first gate node G1 and the first drain region 15 is connected to a first drain node D1. The first gate node G1 and the first drain node D1 are only schematically illustrated in Figures 1A and 1B. These nodes G1, D1 may include metal-lizations (not shown) on top of the semiconductor body 100. Optionally, as illustrated in dashed lines in Figure 1B, a first connection electrode 34 may be embedded in each of the gate regions 14 and a second connection electrode 35 may be embedded in the drain region 15. The first connection electrodes 34 are connected to the gate node G1 and serve to provide a low-ohmic connection between each section of the gate regions 14 and the first gate node G1. The second electrode 35 is connected to the drain node D1 and provides a low-ohmic connection between each section of the drain region 15 and the drain node D1. Further, a third electrode 33 may be embedded in the first source region 13. Referring to Figure 1B, each of the first, second and third connection electrodes 34, 35, 33 may extend along a complete length of the respective semiconductor region 14, 15, 13 in the vertical direction z. Each of these electrodes 34, 35, 33 includes an electrically conducting material. Examples of such electrically conducting materials include, but are not restricted to: a metal such as copper (Cu), aluminum (Al), tantalum (Ta), titanium (Ti), cobalt (Co), nickel (Ni) or tungsten (W); a highly doped polycrystalline semiconductor material such as polysilicon; or a metal silicide, such as tungsten silicide (WSi), titanium silicide (TiSi), Cobalt silicide (CoSi), or nickel silicide (NiSi).

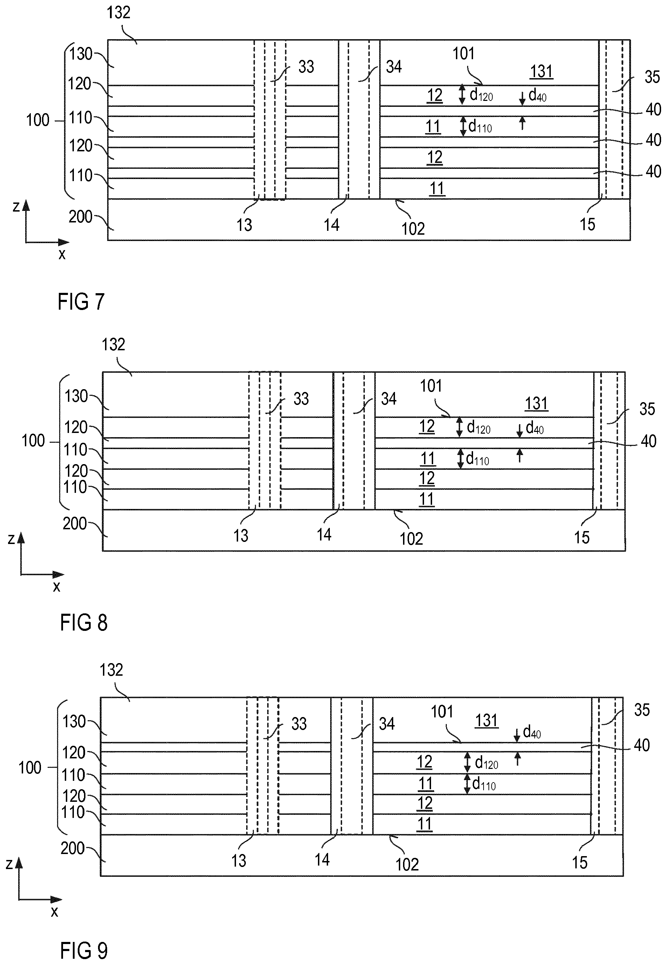

Generally, the main function of the third semiconductor layer 130 is to accommodate the second transistor device M2. Therefore, the semiconductor layer 130 is designed such that it provides sufficient space to integrate active regions of the second semiconductor M2 in the second region 132. According to one example, a thickness of the third semiconductor layer 130 in the second region 132 is at least 1 micrometer (µm), in particular at least 4 micrometers. The "thickness" is the dimension of the third layer 130 in the vertical direction z (see, e.g., Figures 7 and 8). According to one example, a thickness of the third semiconductor layer 130 is at least twice a thickness of a single first semiconductor layer 110 or a single second semiconductor layer 120. According to one example, a thickness of the third semiconductor layer 130 is at least twice a thickness of each of the first semiconductor layers 110 and the second semiconductor layers 120. The thickness of a single first semiconductor layer 110 or a single second semiconductor layer 120 is, for example, between 100 nanometers (nm) and 3 micrometers (µm). According to another example, a thickness of the third semiconductor layer 130 is greater than a distance between the first source region 13 and each of the gate regions 14.

In or on top of the first region 131, the semiconductor arrangement may include an edge termination structure (not shown in Figures 1A to 1C).

At least the first region 131 of the third semiconductor layer 130 is a region of the second doping type so that a first p-n junction is formed between the first drain region 15 and the first region 131 and a second p-n junction is formed between the first source region 13 and the first region 131. These p-n junctions are part of two bipolar diodes, a first bipolar diode BD1 formed by the gate regions 14, the first region 131 and the first drain region 15, and a second bipolar diode BD2 formed by the gate regions 14, the first region 131 and the first source region 13. In each of these bipolar diodes, the first region 131 of the third semiconductor layer 130 forms a base region. Circuit symbols of these bipolar diodes are shown in Figure 1B. According to one example, a doping concentration of the first region 131 of the third semiconductor layer 130 is such that a voltage blocking capability of the first bipolar diode BD1 is equal to or higher than a voltage blocking capability of the first transistor device M1.

The "voltage blocking capability" of the first transistor device M1 is defined by a maximum level of a voltage between the first drain node D1 and the gate node G1, the first transistor device M1 can withstand in an off-state. Dependent on the specific design, the voltage blocking capability may range from 20V up to several 100 volts. This voltage blocking capability may be adjusted, inter alia, by suitably selecting a distance between the first gate region 14 and the first drain region 15. In a first transistor device M1 with a voltage blocking capability of 650 volts, for example, the distance may be selected from between 40 micrometers and 60 micrometers and a doping concentration of the first region 131 may be selected from a range of between 1E12 cm⁻³ and 1E15 cm⁻³, in particular from between 1.1E14 cm⁻³ and 4.6E14 cm⁻³. The doping concentration of the first region 131 may be lower than the doping concentration of the plurality of second semiconductor layers 120, for example.

The layer stack with the first and second semiconductor layers 110, 120 adjoins the third layer 130 and, therefore, the second region 132 in which active regions of the second transistor device M2 are integrated. However, the third layer 130 and, in particular, the second region 132 is not obtained based on the first and second layers 110, 120. That is, the second region 132 is not obtained by additionally doping sections of the first and second layers 110, 120 with dopants of the second doping type in order to obtain an effective doping of the second doping type.

Referring to Figures 1A and 1B, the first source region 13 is electrically connected to a drain node D2 of the second transistor device M2. The second transistor device M2 further includes a gate node G2 and a source node S2. According to one example, the second transistor device M2 is a normally-off transistor device such as, for example, an enhancement MOSFET. Just for the purpose of illustration, the circuit symbol of the second transistor device M2 shown in Figures 1A and 1B represents an n-type enhancement MOSFET. This, however, is only an example. The second transistor device M2 may be implemented as a p-type enhancement MOSFET or a p-type or n-type depletion MOSFET as well.

Optionally, as illustrated in dashed lines in Figure 1B, those sections of the second semiconductor layers 120 that are arranged below the second region 132 and are separated from those sections that form the compensation regions 12 are connected to the second source node S2. Connections between these second layers 120 and the second source node S2 are schematically illustrated in Figure 1B.

The first and second transistor device M1, M2 can be interconnected in various ways. According to one example, the source node S2 of the second transistor device M2 is connected to the gate node G1 of the first transistor device M1. An electronic circuit diagram of a transistor arrangement in which the gate node G1 of the first transistor device M1 is connected to the source node S2 of the second transistor device M2 is shown in Figure 2A. Just for the purpose of illustration and the following explanation it is assumed that the first transistor device M1 is an n-type JFET and the second transistor device M2 is an n-type enhancement MOSFET. The second gate node G2, the second source node S2 and the first drain node D1 are circuit nodes that may serve to connect the transistor arrangement to other devices, a power source, ground or the like in an electronic circuit.

The transistor arrangement may include a housing (package) 300 that is schematically illustrated in Figure 2A. In this case, the second gate node G2, the second source node S2 and the first drain node D1 are external circuit nodes that are accessible outside the housing 300. According to one example, the gate node G1 of the first transistor device M1 is connected to the source node S2 of the second transistor device M2 inside the housing 300. A connection between the second source node S2 and the first gate node G1 may be formed by a wiring arrangement (not shown in the figures) that is located on top of the first surface 101 of the semiconductor body 100. According to another example, the first gate node G1 is accessible outside the housing 300 and the first gate node G1 is connected to the second source node S2 by a connection outside the housing 300.

Although the semiconductor arrangement includes two transistors, first transistor device (JFET) M1 and second transistor device (MOSFET) M2, it can be operated like one single transistor. An operation state of the semiconductor arrangement is defined by an operation state of the MOSFET M2. The semiconductor arrangement acts like a voltage controlled transistor that switches on or off dependent on a drive voltage V_{GS2} received between the second gate node G2 and the second source node S2. This drive voltage is also referred to as gate-source voltage V_{GS2} in the following.

The function of the semiconductor arrangement shown in Figures 1A-1C and 2A is explained below. Just for the purpose of explanation, it is assumed that the first transistor device M1 is an n-type JFET and the second transistor device M2 is an n-type enhancement MOSFET. Furthermore, for the purpose of explanation, it is assumed that the transistor arrangement operates as an electronic switch connected in series with a load Z, wherein a series circuit with the load Z and the transistor device receives a supply voltage V1.

Referring to Figure 2, the MOSFET M2 is controlled by the gate-source voltage V_{GS2} received between the second gate node G2 and the second source node S2. The MOSFET M2 is in an on-state (conducting state) when a voltage level of the gate-source voltage V_{GS2} is higher than a predefined threshold voltage level Vₜₕ₁. In an n-type enhancement MOSFET, the threshold voltage level Vₜₕ₁ is a positive voltage level. The JFET M1 is controlled by a gate-source voltage V_{GS1} received between the first gate node G1 and the first source node S1. An n-type JFET, such as the JFET M1 shown in Figure 2, is in the on-state when a voltage level of the gate-source voltage, such as the gate-source voltage V_{GS1} shown in Figure 2, is higher than a predefined threshold level Vₜₕ₂. That is, the JFET M1 is in the on-state, when V_{GS1} > Vₜₕ₁, where Vₜₕ₁ < 0. As the gate node G1 of the JFET M1 is connected to the source node S2 of the MOSFET M2, the gate-source voltage V_{GS1} of the JFET M1 equals the inverted drain-source voltage V_{DS2} of the MOSFET M2, that is, V_{GS1} = -V_{DS2}. The drain-source voltage V_{DS2} of the MOSFET M2 is the voltage between the drain node D2 and the source node S2 of the MOSFET M2.

When the MOSFET M2 is in the on-state, a magnitude of the drain-source voltage V_{DS2} is very low, so that the gate-source voltage V_{GS1} of the JFET is between the negative threshold level Vₜₕ₁ and zero. Thus, the JFET M1 is also in the on-state. When the MOSFET M2 switches off, the drain-source voltage V_{DS2} increases until the inverted drain-source voltage -V_{DS2} reaches the negative threshold voltage Vₜₕ₁, so that the JFET M1 also switches off.

Referring to Figures 1A-1C, in the on-state of the JFET M1 and the MOSFET M2, a current can flow from the first drain node D1 via the drain region 15, the drift regions 11, the first source region 13, and the drain-source path D2-S2 of the MOSFET M2 to the second source node S2. When the MOSFET M2 switches off, the electrical potential at the first drain node D1 can increase relative to the electrical potential at the second source node S2. This increase of the electrical potential at the first drain node D1 causes an increase of the electrical potential at the first source region 13, while the electrical potential at the gate regions 14 is tied to the electrical potential at the second source node S2. The increase of the electrical potential of the first source region 13 and the drift regions 11 causes p-n junctions between the first source region 13 and the compensation regions 12, and between the gate regions 14 and the drift regions 11 to be reverse biased. Furthermore, p-n junctions between the drift regions 11 and the compensation regions 12 are reverse biased. Reverse biasing those p-n junctions causes the drift regions 11 to be depleted of charge carriers. The JFET M1 switches off as soon as the drift regions 11 between the at least two gate regions 14 and/or between the gate regions 14 and the first source region 13 have been completely depleted of charge carriers.

Figure 1C shows a horizontal cross sectional view of the transistor device in a horizontal section plane C-C going through one of drift regions 11. In Figure 1C, reference character 11₁ denotes a section of the drift region 11 between two gate regions 14, and 11₂ denotes a section of the at least one drift region 11 between the gate regions 14 and the first source region 13. The threshold voltage Vₜₕ₁ of the JFET M1 is the voltage that needs to be applied between the gate regions 14 and the first source region 13 in order to completely deplete at least one of these sections 11₁, 11₂. In Figures 1C, d14 denotes a distance between two gate regions 14 in the second direction y. The magnitude (the level) of the threshold voltage Vₜₕ₁ is dependent on several design parameters and can be adjusted by suitably designing these parameters. These design parameters include the (shortest) distance d14 between two gate regions 14, a doping concentration of the drift region 11 in the section 11₁ between the gate regions 14, and a doping concentration of the compensations regions 12 (out of view in Figure 1C) in a section that is located between the gate regions 14 and adjoins section 11₁ of the drift regions 11.

According to one example, the drift regions 11 in the sections 11₁ between the gate electrodes 14 include a higher doping concentration than in sections 11₂ spaced apart from the gate regions 14 in the direction of the drain region 13. This higher doped section 11₁ counteracts an increase in the on-resistance caused by the gate regions 14, which reduce the cross section in which a current can flow between the source and drain regions 13 and 15. According to one example, the compensation regions 12 at least in parts of sections 11₁ arranged between the gate regions 14 include a higher doping concentration than in other sections, in particular, those sections 11₃ spaced apart from the gate electrodes 14 in the direction of the drain region 15. This higher doped section ensures that the drift regions 11 in the section 11₁ between the gate regions 14 are depleted of charge carriers, so that the JFET M1 blocks, when the threshold voltage Vₜₕ₁ is applied. According to one example, the higher doped region of the compensation regions 12 is not only arranged between the gate regions 14, but surrounds the gate regions 14 in a horizontal plane, which is a plane parallel to the first surface 101.

The MOSFET M2 is designed such that a voltage blocking capability of this MOSFET M2 equals or is higher than a magnitude of threshold voltage Vₜₕ₁ of the JFET M1, that is V_{DS2_MAX} ≥ |Vₜₕ₁|, where V_{DS2_MAX} is the voltage blocking capability of the MOSFET M2. The voltage blocking capability of the MOSFET M2 is the maximum voltage, the MOSFET M2 can withstand between the drain node D2 and the gate node G2.

In the example shown in Figure 2A, the semiconductor arrangement includes three external circuit nodes, the first drain node D1, the second source node S2, and the second gate node G2. According to another example shown in Figure 2B, additionally to these circuit nodes D1, S2, G2, the first source node S1 is also accessible. According to yet another example shown in Figures 2C, the second transistor M2 may be deactivated by connecting the second gate node G2 with the second source node S2. In this case, only the first transistor device M1 is active and can be driven by applying a drive voltage V_{GS1} between the first gate node G1 and the first source node S1. According to one example, the first drain node D1, the first gate node G1, the first source node S1, the second gate node G2, and the second source node S2 are external circuit nodes that are accessible outside the housing 300. In this case, a user/costumer may choose one of the configurations shown in Figures 2A to 2C by suitably connecting these circuit nodes D1, G1, S1, G2, and S2. Figure 2D illustrates another example. In this example, the source nodes S1, S2, the drain nodes D1, D2, and the gate nodes G1, G2 of each of the first and second transistor device M1, M2 are accessible outside of the housing 300.

According to one example, the first and second layers 110, 120 are implemented such that the drift regions 11 and the compensation regions 12 are essentially balanced with regard to their dopant doses. That is, at each position in the current flow direction of the first transistor device, the amount of dopant atoms (dopant charges) in one drift region 11 essentially corresponds to the amount of dopant atoms in the neighboring compensation region 12. "Essentially" means that there may be an imbalance of up to +/-10%. That is, there may be 10% more or less dopant atoms in the drift regions 11 than in the compensation regions 12. Thus, when the first transistor device M1 is in the off-state and depletion regions (space charge regions) expand in the drift and compensation regions 11, 12 essentially each doping atom in each drift region 11 has a corresponding doping atom (which may be referred to as counter doping atom) of a complementary doping in the compensation regions 12 and the drift and compensation regions 11, 12 can completely be depleted. As commonly known, compensation regions in a superjunction transistor device, e.g., JFET M1 shown in Figures 1A-1C and 2A-2D, make it possible to implement the drift regions with a higher doping concentration than in a conventional, non-superjunction device. This reduces the on-resistance, which is the electrical resistance in the on-state, without decreasing the voltage blocking capability.

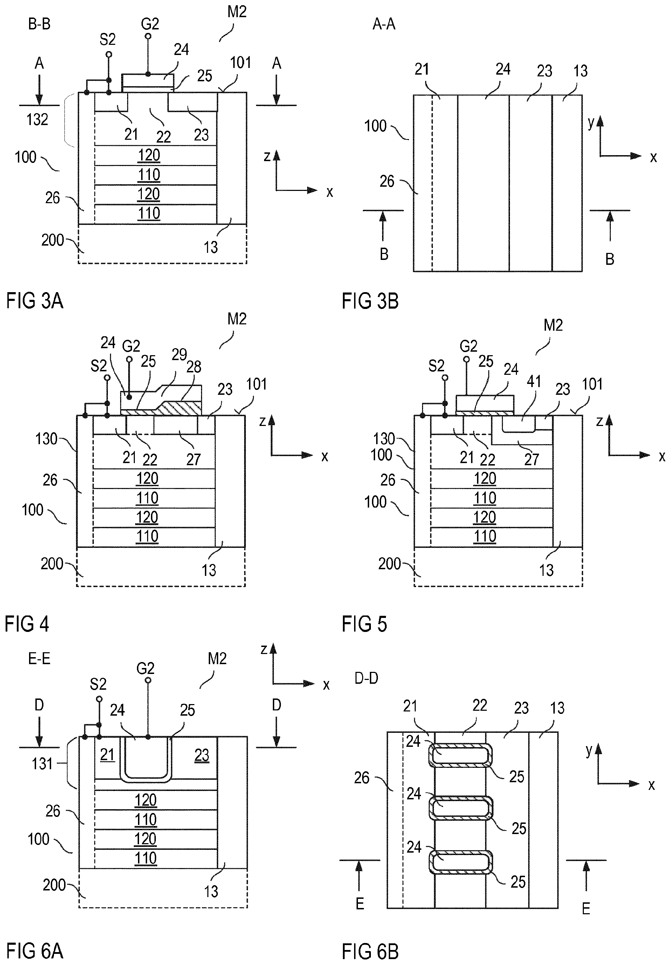

Referring to the above, the second transistor device M2 may be implemented in various ways. Some examples for implementing the second transistor M2 are explained with reference to Figures 3A-3B, 4, 5 and 6A-6B below. Figures 3A and 3B show a first example of the second transistor device M2, wherein Figure 3A shows a vertical cross sectional view and Figure 3B shows a horizontal cross sectional view of the second transistor device M2. Referring to Figure 3A, the second transistor device M2 includes a source region 21 and a drain region 23 spaced apart from the source region 21 in the first lateral direction x. The drain region 23 adjoins the source region 13 of the first transistor device M1 in order to electrically connect the source region 13 of the first transistor device M1 with the drain region 23 of the second transistor device M2. The drain region 23 of the second transistor device M2 is also referred to as second drain region in the following. The source region 21 of the second transistor device M2, which is also referred to as second source region 21 in the following, and the second drain region 23 are separated by a body region 22. The body region 22 has a doping type that is complementary to the doping type of the second source region 21 and the second drain region 23. A doping concentration of the body region 22 is, for example, selected from a range of between 1E16 cm⁻³ and 1E19 cm⁻³, in particular from between 1E17 cm⁻³ and 1E18 cm⁻³.

The second transistor device M2 may be implemented as an enhancement device (normally-off device) or a depletion device (normally on-device). In a normally-off device, the body region 22 adjoins the gate dielectric 25 (and the gate electrode 24, in the on-state of the second transistor device M2, generates an inversion channel in the body region 22 along the gate dielectric 25). In a normally-on device, a channel region (not shown) of the first doping type is arranged between the body region 22 and the gate dielectric 25 and extends from the second source region 21 to the second drain region 23 (and the gate electrode 24, in the off-state of the second transistor device M2, depletes the channel region of charge carriers).

In the example shown in Figures 3A and 3B the second drain region 23 adjoins the first source region 13. This, however, is only an example. According to another example (not shown), the second drain region 23 and the first source region 13 are connected via a wiring arrangement located on top of the first surface 101 of the semiconductor body 100.

Referring to Figure 3A, a gate electrode 24 is arranged adjacent to the body region 22 and dielectrically insulated from the body region 22 by a gate dielectric 25. This gate electrode 24 is electrically connected to the second gate node G2. The second source region 21 is electrically connected to the second source node S2. According to one example, the second transistor device M2 is an n-type transistor device. In this case, the second source region 21 and the second drain region 23 are n-doped, while the body region 22 is p-doped. According to another example, the second transistor device M2 is a p-type transistor device. In this case, the second source region 21 and the second drain region 23 are p-doped semiconductor regions, while the body region 22 is an n-doped semiconductor region. The second transistor device M2 shown in Figure 3A is an enhancement transistor device. In this transistor device, the body region 22 adjoins the gate dielectric 25. According to another example (not shown), the second transistor device M2 is a depletion transistor device. In this case, there is a channel region of the same doping type as the second source region 21 and the second drain region 23 arranged between the body region 22 and the gate dielectric 25 and extends from the second source region 21 to the second drain region 23. Referring to Figure 3B, which shows a horizontal cross sectional view of the second transistor device M2, the second source region 21, the second drain region 23, and the body region 22 may be elongated in the second lateral direction y of the semiconductor body 100.

Referring to Figure 3B, a connection region 26 of the second doping type may be connected to the second source node S2 and extend through the second region 132 and the layer stack with the first and second layers 110, 120. This connection region 26 connects those sections of the second layers 120 that are arranged below the second region 132 to the second source region S2. Those sections of the first layers 110 that are arranged below the second region 132 are connected to the first source region 13 and, as the first source region 13 is connected to the second drain region 23, to the second drain region 23. Because of the fact that, below the second region 132, the second layers 120 are connected to the second source node S2 and that the first layers 110 are connected to the second drain node D2 a depletion region can expand in the first and second layer sections 110, 120 below the second region 132 when the second transistor device M2 is in the off-state.

Figure 4 shows a modification of the transistor device shown in Figures 3A and 3B. In this modification, the transistor device M2 includes a drift region 27 (which may also be referred to as drain extension) between the body region 22 and the drain region 23. The drift region 27 has a lower doping concentration than the drain region 23 and the same doping type as the drain region 23. A field electrode 29 is adjacent the drift region 27 and dielectrically insulated from the drift region 27 by a field electrode dielectric 28. According to one example, the field electrode dielectric 28 is thicker than the gate dielectric 25. As illustrated, the field electrode 29 may be electrically connected with the gate electrode 24, for example, by forming the gate electrode 24 and the field electrode as one conductive layer. This is illustrated in Figure 4. According to another example (not shown), the field electrode 29 is electrically connected to the second source node S2 and electrically insulated from the gate electrode 24.

Figure 5 shows another modification of the transistor device shown in Figures 3A and 3B. In the example shown in Figure 5, the gate electrode 24 and the gate dielectric 25 overlap the drift region 27, but, in the first lateral direction x, do not extend to the drain region 23. An insulation region 41 is arranged between the drift region 27 and those regions of the first surface 101 that are not covered by the gate electrode 24 and the gate dielectric 25. This insulation region 41 may adjoin the drain region 23, as shown in Figure 5. In this example, the drift region 27 adjoins the drain region 23 in a region spaced apart from the first surface 101. The insulation region 41 may include a conventional electrically insulating material such as an oxide. The insulation region 41 may be implemented as a so called STI (Shallow Trench Isolation) and include a thermally grown oxide.

In the example shown in Figures 3A, 4, and 5, the gate electrode 24 is arranged on top of the first surface 101 of the semiconductor body 100. This, however, is only an example. According to another example shown in Figures 6A and 6B, there are several gate electrodes 24 that are arranged in trenches extending from the first surface 101 into the semiconductor body 100. Each of these gate electrodes 24, in the first lateral direction x, extends from the second source region 21 to the second drain region 23 through the body region 22 and is dielectrically insulated from these semiconductor regions 21, 22, 23 by a gate dielectric 25. Each of these gate electrodes 24 is electrically connected to the second gate node G2, which is schematically illustrated in Figure 6A.

Second transistor devices of the type shown in Figures 3A to 3B, 4, 5 and 6A to 6B can be implemented using conventional implantation and oxidation processes known from integrated CMOS (Complementary Metal Oxide Semiconductor) processes. The second transistor device may therefore also be referred to as CMOS device. The second region 132 may have a basic doping of the second doping type or may be intrinsic before forming the active regions (source, body and drain regions 21, 22, 23) of the second transistor device M2 in the second region 132. The basic doping concentration can be selected such that it essentially equals the doping concentration of the body region 22 or is lower than the doping concentration of the body region 22.

Now referring to Figure 7, a semiconductor device according to another example is schematically illustrated. Figure 7 schematically illustrates a vertical cross sectional view of a semiconductor device. The semiconductor device is similar to the semiconductor device as has been described with respect to Figure 1B above. That is, the semiconductor device comprises a layer stack with a plurality of first semiconductor layers 110 of a first doping type and a plurality of second semiconductor layers 120 of a second doping type complementary to the first doping type. The first semiconductor layers 110 and the second semiconductor layers 120 are arranged alternatingly between a first surface 101 and a second surface 102 of the layer stack. The semiconductor device further comprises a first semiconductor region 15 of a first semiconductor device M1 adjoining the plurality of first semiconductor layers 110, and at least one second semiconductor region 14 of the first semiconductor device M1, wherein each of the at least one second semiconductor region 14 adjoins at least one of the plurality of second semiconductor layers 120, and is spaced apart from the first semiconductor region 15. The semiconductor device further comprises at least one barrier layer 40 configured to form a diffusion barrier. Each of the at least one barrier layer 40 is arranged in parallel to the first surface 101 and to the second surface 102, and may be arranged adjacent to one of the first semiconductor layers 110, or adjacent to one of the second semiconductor layers 120, or both.

In the example illustrated in Figure 7, the semiconductor device comprises a plurality of barrier layers 40, wherein a barrier layer 40 is arranged between each first semiconductor layer 110 and its neighboring second semiconductor layer(s) 120. That is, each first semiconductor layer 110 is separated from its neighboring second semiconductor layer(s) 120 by a barrier layer 40. This, however, is only an example. As is illustrated in the vertical cross sectional view in Figure 8, it is also possible that the semiconductor device only comprises a single (one) barrier layer 40 that is arranged between one of the first semiconductor layers 110 and a neighboring second semiconductor layer 120. Any other number of barrier layers 40 is generally possible. That is, a barrier layer 40 may be arranged between some, but not all, of the first semiconductor layers 110 and one or more of its neighboring second semiconductor layers 120.

According to an even further example (illustrated in Figure 9), a barrier layer 40 may be arranged on top of the layer stack adjacent to the first surface 101. That is, e.g., a barrier layer 40 may be arranged between the layer stack and the first surface 101. According to another example (not illustrated), a barrier layer 40 may be arranged below the layer stack adjacent to the second surface 102. That is, e.g., a barrier layer 40 may be arranged between the layer stack and the second surface 102. Any combination of the different examples is possible. That is, one or more barrier layers 40 may be arranged between two or more layers of the layer stack (see Figures 7 and 8), and additionally a barrier layer 40 may be arranged between the layer stack and the first surface 101, or between the layer stack and the second surface 102, or both.

The at least one barrier layer 40 is configured to form a diffusion barrier. That is, a barrier layer 40 that is arranged between a first semiconductor layer 110 and a second semiconductor layer 120 prevents (dopant) atoms or charges of the first semiconductor layer 110 from diffusing into the second semiconductor layer 120 and vice versa. In this way, a sharp boundary may be formed between the first semiconductor layers 110 of the first doping type and the second semiconductor layers 120 of the second doping type.

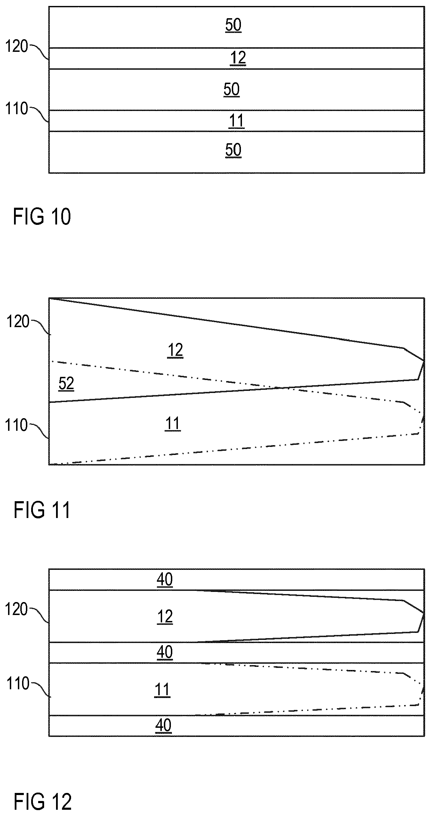

This is exemplarily illustrated by means of Figures 10 - 12, wherein Figure 10 illustrates an ideal doping profile, Figure 11 illustrates a real doping profile of a conventional semiconductor arrangement, and Figure 12 illustrates a real doping profile of an exemplary semiconductor arrangement as described herein. As can be seen in Figure 10, in an ideal doping profile there are sharp layers 110, 120 that are clearly separated from each other by separating layers 50, wherein no doping atoms diffuse into the separating layers 50. The doping concentration within the first layer 110 and within the second layer is constant throughout the respective layer. In reality, however, interdiffusion occurs between neighboring layers 110, 120 of different doping types, as is illustrated in Figure 11. The doping concentrations in the first semiconductor layer 110 and a neighboring second semiconductor layer 120 follows a Gaussian broadened profile. Atoms of the first doping type diffuse from the first semiconductor layer 110 into the second semiconductor layer 120 and atoms of the second doping type diffuse from the second semiconductor layer 120 into the first semiconductor layer 110. Therefore, there may be interdiffusion regions 52 comprising both atoms of the first doping type as well as of the second doping type.

Now referring to Figure 12, by arranging barrier layers 40 between a first semiconductor layer 110 and a neighboring second semiconductor layer 120, such interdiffusion regions 52 may be prevented. Dopant atoms of the first doping type are prevented from diffusing out of the first semiconductor layer 110 and dopant atoms of the second doping type are prevented from diffusing out of the second semiconductor layer 120. The distribution of the dopant atoms within the respective regions, however, may not be constant. That is, the first layers 110 and the second layers 120 do not have all characteristics of the ideal layers of Figure 10. However, a semiconductor device comprising at least one barrier layer 40 between a first semiconductor layer 110 and a second semiconductor layer 120 still shows several enhanced properties as compared to conventional arrangements without barrier layers 40 (see Figure 11).

If interdiffusion occurs between neighboring layers 110, 120 of different doping types (no barrier layer 40 arranged between the two layers), the resulting dopant loss in the concerned layers may result in a reduced process window during a diffusion process and may further result in a reduced mobility of the dopant atoms. If not enough dopants are present in one or more of the layers 110, 120, this decreased dopant concentration may lead to an early pinch off of the pn-diode (BD1, BD2, see Figure 1B above). Further, if the distance between two neighboring layers of different doping types is too small, tunneling may occur which may lead to a substantial leakage if a voltage is applied to the pn-junction that is formed between two neighboring layers 110, 120 of different doping types. If a first semiconductor layer 110 and a neighboring second semiconductor layer 120 are separated by a barrier layer 40, a thickness d₁₁₀ of the first semiconductor layer 110 in the vertical direction z may be smaller than in a semiconductor device without a barrier layer. The same applies for the thickness d₁₂₀ of the second semiconductor layers 120.

A barrier layer 40 that is arranged above (between the layer stack and the first surface 101) or below (between the layer stack and the second surface 102) the layer stack may have a somewhat different function than a barrier layer 40 that is arranged between a first semiconductor layer 110 and a second semiconductor layer 120. For example, a barrier layer 40 above or below the layer stack may prevent the penetration of unwanted interface charges or interstitials into the layer stack, without negatively affecting the electric conductivity of the semiconductor device. As a consequence, preventing the penetration of unwanted interface charges or interstitials into the layer stack results at least in a reduced diffusion of dopant atoms from the outermost first or second semiconductor layers 110, 120 into neighboring regions. In some cases, the diffusion of dopant atoms from the outermost first or second semiconductor layers 110, 120 into neighboring regions may be prevented entirely. For example, a barrier layer 40 above the layer stack may prevent dopant atoms from the topmost layer (e.g., second semiconductor layer 120 in the example of Figure 9) from diffusing into the third semiconductor layer 130. On the other hand, a barrier layer 40 below the layer stack may prevent dopant atoms from the lowermost layer (e.g., first semiconductor layer 110 in the example of Figure 9) from diffusing into a carrier 200. Generally speaking, a barrier layer 40 may prevent unwanted atoms or charges from migrating into the layer stack or out of the layer stack in the vertical direction z. In this way, the initial dopant profiles (e.g., implanted profile or in situ doped profile) of the semiconductor layers 110, 120 may be essentially maintained, and the dopant profiles may be decoupled from the thermal budget of any following processing steps.

The at least one barrier layer 40 which forms a diffusion barrier may be an undoped semiconductor layer comprising a semiconductor material such as, for example, silicon (Si), silicon carbide (SiC), gallium nitride (GaN), gallium arsenide (GaAs), or the like. The semiconductor material of the barrier layer 40 may be the same semiconductor material that is used to form the first and second semiconductor layers 110, 120, for example. The at least one barrier layer 40 comprising an undoped semiconductor material may further comprise a plurality of foreign atoms that are implanted into the semiconductor material. According to one example, a barrier layer 40 may comprise silicon. The foreign atoms may comprise at least one of oxygen, nitrogen, carbon, fluorine, and carbon-oxygen. For example, oxygen atoms may be inserted in interstices in the silicon lattice. A concentration of foreign atoms in each of the at least one barrier layer 40 may be between 1E19 cm-³ and 1E23 cm-³, for example.

According to another example, a barrier layer 40 may be a non-semiconductor layer. That is, the barrier layer 40 may comprise a material that is not a semiconductor material (non-semiconductor material). The non-semiconductor material may comprise at least one of oxygen, nitrogen, carbon, fluorine, and carbon-oxygen, for example. According to one example, a monolayer of a non-semiconductor material is formed adjacent to a semiconductor layer 110, 120 in order to prevent diffusion into or out of the semiconductor layer 110, 120. Forming a thin monolayer of a non-semiconductor material, however, is only an example. The barrier layer 40 may also be a layer that is thicker than a monolayer.

A thickness d₁₁₀ of each of the plurality of first semiconductor layers 110 in the vertical direction z may be between 100nm and 5µm, for example. A thickness d₁₂₀ of each of the plurality of second semiconductor layers 120 may also be between 100nm and 5 um, for example. The thickness d₁₁₀ of the first semiconductor layers 110 may equal the thickness d₁₂₀ of the second semiconductor layers 120 or may differ from the thickness d₁₂₀ of the second semiconductor layers 120. The thickness d₄₀ of each of the at least one barrier layer 40 in the vertical direction z may be (significantly) smaller than the thicknesses d₁₁₀, d₁₂₀ of the first and second semiconductor layers 110, 120. According to one example, the thickness d₄₀ of each of the barrier layers 40 may be between 1nm and 100nm. A comparably thin barrier layer 40 may be sufficient to form a diffusion barrier.

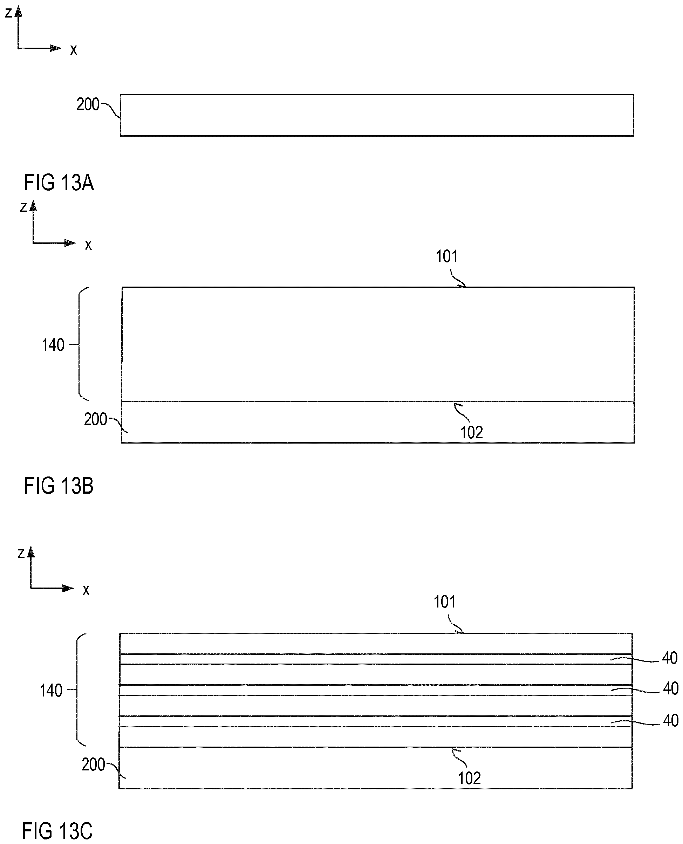

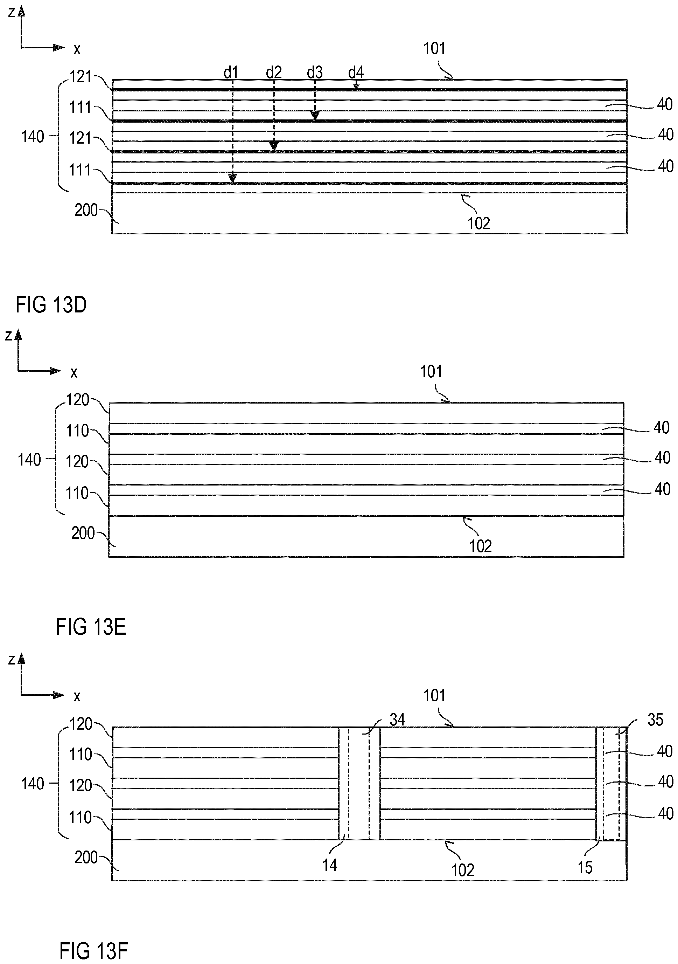

Now referring to Figure 13, a method for producing a semiconductor device is exemplarily illustrated. Referring to Figure 13A, a carrier 200 may be formed or provided. The carrier 200 may be made of a semiconductor material, for example, such as silicon (Si), silicon carbide (SiC), gallium nitride (GaN), gallium arsenide (GaAs), or the like. Now referring to Figure 13B, an epitaxial layer 140 is formed on the carrier 200 in the vertical direction z. Forming the epitaxial layer 140 may comprise depositing a layer of semiconductor material on the carrier 200. For example, the layer of semiconductor material 140 may include a conventional semiconductor material such as, for example, silicon (Si), silicon carbide (SiC), gallium nitride (GaN), gallium arsenide (GaAs), or the like. Now referring to Figure 13C, at least one barrier layer 40 may be formed in the epitaxial layer 140. The at least one barrier layer 40 may be formed by implanting foreign atoms into the epitaxial layer 140, for example. Different barrier layers 40 may be formed at different distances from the first surface 101 in the vertical direction z. As has been described above with respect to Figures 7, 8 and 9, it is also possible that only one barrier layer 40 is formed. It is also possible, that a barrier layer 40 is formed adjacent to the second surface 102, that is, between the carrier 200 and the epitaxial layer 140. In accordance with the example of Figure 9, it is also possible that a barrier layer 40 is formed adjacent to the first surface 101.

In the example illustrated in Figures 13B and 13C, only one epitaxial layer 140 is formed and one or more barrier layers 40 are formed in this epitaxial layer 140. It is, however, also possible to perform multiple successive deposition and implantation steps. That is, for example, a first epitaxial layer may be formed on the carrier 200, followed by an implanting step for forming one or more barrier layers 40. This may be followed by forming a further epitaxial layer and performing a further implanting step, and so forth.

After depositing at least one epitaxial layer 140 and forming at least one barrier layer 40, a plurality of implantation regions 111, 121 is formed in the semiconductor material. This is schematically illustrated in Figure 13D. In the example illustrated in Figure 13D, four implantation regions 111, 121 are formed. This, however, is only an example. According to another example, at least six implantation regions 111, 121 may be formed in the semiconductor material. At least two first implantation regions 111 of a first type may be formed at different vertical positions of the layer of semiconductor material 140. At least two second implantation regions 121 may be formed of a second type that is complementary to the first type of the first implantation regions 111. According to another example, at least three first implantation regions 111 and at least three second implantation regions 121 are formed. For example, the first type may be an n-type implantation region and the second type may be a p-type implantation region, or vice versa. The number of implantation regions 111, 121 that are formed in the epitaxial layer 140 may equal the desired number of first and second semiconductor layers 110, 120. Each implantation region 111, 121 may either be of the first type or the second type, with implantation regions of the first 111 and the second type 121 arranged alternatingly in the vertical direction z. The different implantation regions 111, 121 may be formed at different distances d1, d2, d3, d4 from the first surface 101 in the vertical direction z. The distance dn between an implantation region 111, 121 and the first surface 101 generally depends on the implantation energy that is used to form the implantation region 111, 121.

Now referring to Figure 13E, after forming first and second implantation regions 111, 121, the arrangement may be heated. By heating the first and second implantation regions 111, 121, the implanted ions may be diffused, thereby forming first and second layers 110, 120. Such diffusing processes are generally known and will, therefore, not be described in further detail herein. During this diffusion process, barrier layers 40 that are arranged between a first implantation region 111 and a neighboring second implantation region 121 prevent ions from diffusing out of the respective semiconductor layer 110, 120. A barrier layer 40 arranged between the carrier 200 and the epitaxial layer 140 prevents ions from diffusing from the epitaxial layer 140 into the carrier 200, for example. A barrier layer 40 arranged between the carrier 200 and the epitaxial layer 140 further prevents ions or interstitials from diffusing from the carrier into the epitaxial layer 140.

The resulting first and second semiconductor layers 110, 120 are arranged alternatingly, forming a layer stack, similar to the layer stack that has been described with respect to Figure 7 above. In Figure 13E, four first and second semiconductor regions 110, 120 are exemplarily illustrated. The layer stack, however, may include more than four first and second semiconductor layers 110, 120, as has been described with respect to Figure 1 above. Optionally, a third semiconductor layer 130 (not illustrated in Figure 13) may be formed on a top surface 101 of the layer stack. A top surface 101 of the layer stack is a surface facing away from the carrier 200. The third semiconductor layer 130 may comprise monocrystalline semiconductor material. According to one example, the third layer 130 includes monocrystalline silicon (Si). The optional third semiconductor layer 130 may be formed before or after forming the first and second implantation regions 111, 121.

After forming the layer stack, the at least one barrier layer 40, and the optional third layer 130, a first semiconductor device may be formed. The first semiconductor device may be at least partially integrated in the layer stack. Referring to Figure 13F, forming the first semiconductor device may comprise forming a first semiconductor region 15 in the layer stack adjoining the plurality of first semiconductor layers 110, and forming at least one second semiconductor region 14 in the layer stack, each of the at least one second semiconductor regions 14 adjoining at least one of the plurality of second semiconductor layers 120. Each of the at least one second semiconductor region 14 is spaced apart from the first semiconductor region 15 in a horizontal direction x. The first semiconductor device may comprise a diode, for example, the first semiconductor region 15 forming a cathode of the diode and the at least one second semiconductor region 14 forming an anode of the diode, or vice versa.

Optionally, a third semiconductor region 13 may be formed adjoining the plurality of first semiconductor layers 110 (not illustrated in Figure 13). The first semiconductor region 15 may be spaced apart from the third semiconductor region 13 in the first direction x, and the at least one second semiconductor region 14 may be arranged between the third semiconductor region 13 and the first semiconductor region 15, and spaced apart from the third semiconductor region 13. In this way, a semiconductor device may be formed similar to the exemplary semiconductor devices of Figures 7, 8 and 9 above. The first, second, and third semiconductor regions 15, 14, 13 may correspond to the first source region 13, the first drain region 15, and the plurality of gate regions 14 of the examples illustrated in Figures 1 to 6 above. Optionally, first, second, and third connection electrodes 34, 35, 33 may be formed extending along a complete length of the respective semiconductor region 14, 15, 13 in the vertical direction z, as has already been described above.

Optionally, a second transistor device M2 may be formed (see Figures 1 to 6 above) that is at least partly integrated in a second section 132 of a third semiconductor layer 130.

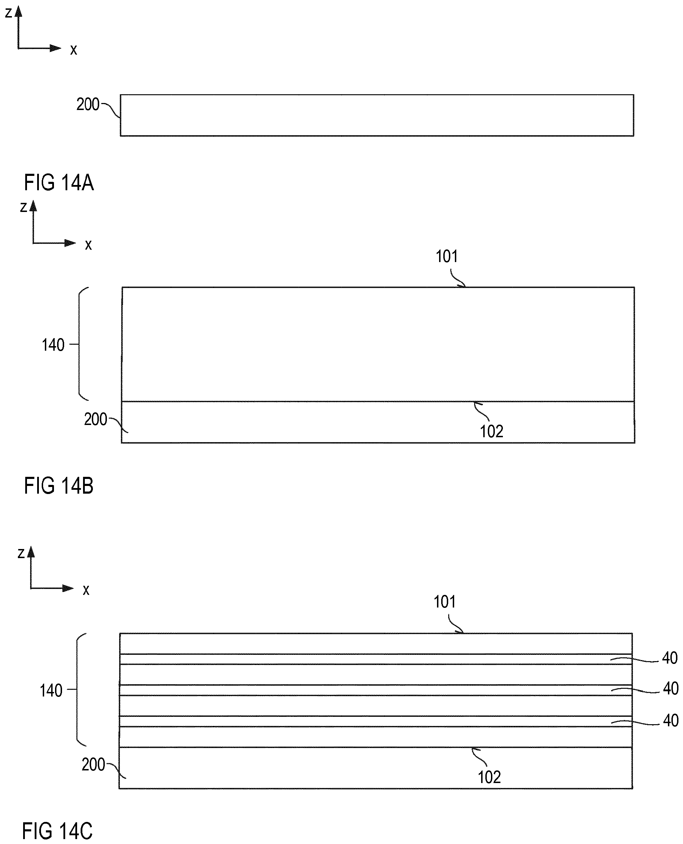

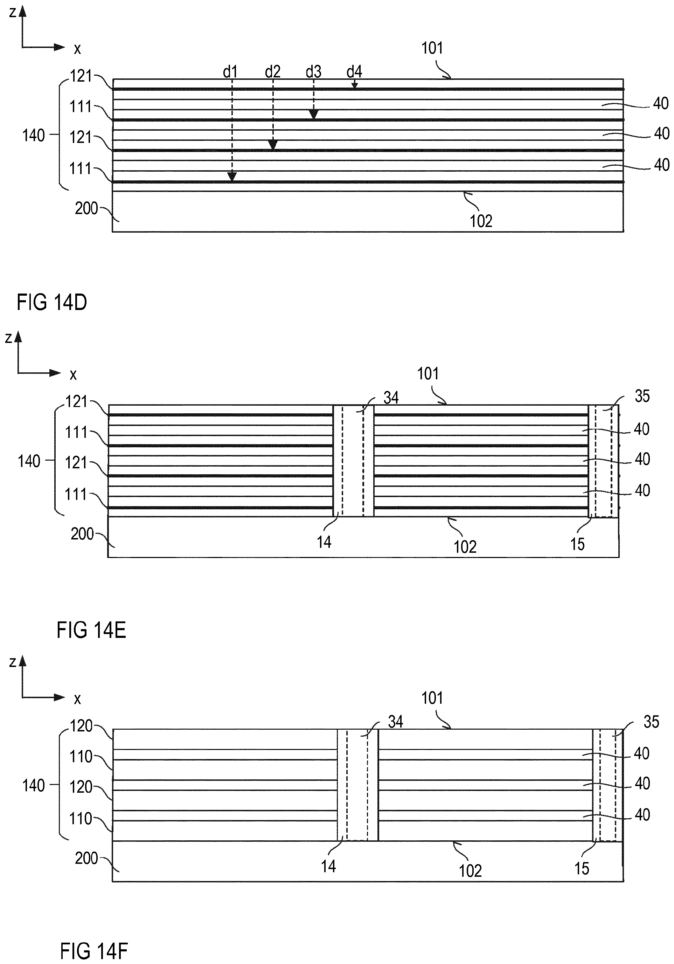

Now referring to Figure 14, another method for producing a semiconductor device is exemplarily illustrated. The method is similar to the method that has been described with respect to Figure 13 above. However, according to the example illustrated in Figure 14, the first semiconductor region 15 and the at least one second semiconductor region 14 are formed before performing the step of heating the first and second implantation regions 111, 121, thereby diffusing the implanted ions and forming first and second layers 110, 120. That is, the steps illustrated in Figures 14A, 14B, 14C and 14D correspond to the steps that have been described with respect to Figures 13A, 13B, 13C and 13D above. Then, as is illustrated in Figure 14E, the first semiconductor region 15 and the at least one second semiconductor region 14 are formed. Optionally, a third semiconductor region 13 may also be formed at this stage. Afterwards, the step of heating the first and second implantation regions 111, 121 may be performed, as has already been described above with respect to Figure 13E.

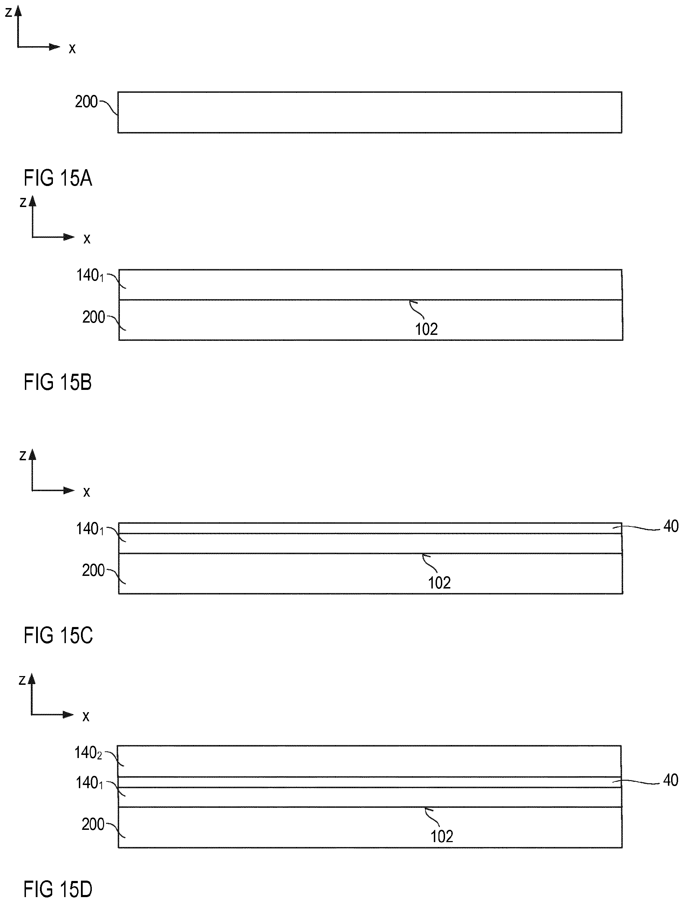

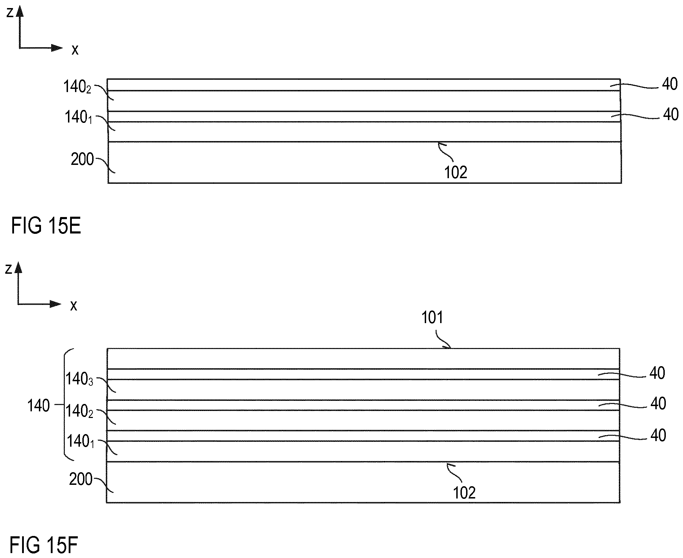

Now referring to Figure 15, another method for producing a semiconductor device is exemplarily illustrated. Referring to Figure 15A, a carrier 200 may be formed or provided. The carrier 200 may be made of a semiconductor material, for example, such as silicon (Si), silicon carbide (SiC), gallium nitride (GaN), gallium arsenide (GaAs), or the like. Now referring to Figure 15B, a first sub-layer 140₁ of an epitaxial layer 140 is formed on the carrier 200 in the vertical direction z. Forming the first sub-layer 140₁ may comprise depositing a layer of semiconductor material on the carrier 200. For example, the first sub-layer 140₁ may include a conventional semiconductor material such as, for example, silicon (Si), silicon carbide (SiC), gallium nitride (GaN), gallium arsenide (GaAs), or the like. After depositing a first sub-layer 140₁ of semiconductor material, a barrier layer 40 may be deposited on the first sub-layer 140₁. Deposition of a further sub-layer 140₂ may follow (see Figure 15D), again followed by the deposition of a barrier layer 40 (Figure 15E), and so on (Figure 15F). In the example illustrated in Figure 15, a plurality of barrier layers 40 is formed. This, however, is only an example. As has been described above with respect to Figures 7, 8 and 9, it is also possible that only one barrier layer 40 is formed. It is also possible, that a barrier layer 40 is formed adjacent to the second surface 102, that is between the carrier 200 and a first sub-layer 140₁. In accordance with the example of Figure 9, it is also possible that a single epitaxial layer 140 (a single sub-layer 140₁) is formed on the carrier 200, and a barrier layer 40 is formed on or below this single epitaxial layer 140.

Depositing the at least one barrier layer 40 may comprise an epitaxial crystal growth method, a chemical vapor deposition method (CVD), or an atomic layer deposition method (ALD), for example. While depositing the semiconductor or non-semiconductor material of the at least one barrier layer 40, foreign atoms such as oxygen, nitrogen, carbon, fluorine, or carbon-oxygen, for example, may be introduced into the semiconductor or non-semiconductor material. For example, oxygen or carbon atoms may be inserted in interstices in a silicon lattice during the growth of a barrier layer 40. As has been described above, it is also possible to deposit a monolayer of a non-semiconductor material such as oxygen, for example, to form a barrier layer 40.

The subsequent methods steps following the steps described in Figures 15A - 15F are similar to the steps that have been described with respect to Figures 13E - 13F and 14E - 14F above.

## Claims

1. A semiconductor device, comprising:
a layer stack with a plurality of first semiconductor layers (110) of a first doping type and a plurality of second semiconductor layers (120) of a second doping type complementary to the first doping type, wherein the first semiconductor layers (110) and the second semiconductor layers (120) are arranged alternatingly between a first surface (101) and a second surface (102) of the layer stack;
a first semiconductor region (15) of a first semiconductor device (M1) adjoining the plurality of first semiconductor layers (110);
at least one second semiconductor region (14) of the first semiconductor device (M1), wherein each of the at least one second semiconductor region (14) adjoins at least one of the plurality of second semiconductor layers (120), and is spaced apart from the first semiconductor region (15); and
at least one barrier layer (40) configured to form a diffusion barrier, wherein each of the at least one barrier layer (40) is arranged in parallel to the first surface (101) and to the second surface (102) and adjacent to one of the first semiconductor layers (110), or adjacent to one of the second semiconductor layers (120), or both.

2. The semiconductor device of claim 1, wherein each of the at least one barrier layer (40) is
an undoped semiconductor layer comprising a semiconductor material and a plurality of foreign atoms implanted into the semiconductor material; or
a non-semiconductor layer.

3. The semiconductor device of claim 2, wherein at least one of
the semiconductor material comprises silicon; and
the foreign atoms or the non-semiconductor layer comprise at least one of oxygen, nitrogen, carbon, fluorine, and carbon-oxygen.

4. The semiconductor device of any of claims 1 to 3, wherein
a thickness (d₁₁₀) of each of the plurality of first semiconductor layers (110) in a vertical direction (z) is between 100nm and 5µm, wherein the vertical direction (z) is perpendicular to the first surface (101);
a thickness (d₁₂₀) of each of the plurality of second semiconductor layers (120) in the vertical direction (z) is between 100nm and 5µm; and
a thickness (d₄₀) of each of the at least one barrier layer (40) in the vertical direction (z) is between 1nm and 100nm.

5. The semiconductor device of one of the preceding claims, wherein
one of the at least one barrier layer (40) is arranged adjacent to the first surface (101); or
one of the at least one barrier layer (40) is arranged adjacent to the second surface (102);
or both.

6. The semiconductor device of one of the preceding claims, wherein a barrier layer (40) is arranged between each of the plurality of first semiconductor layers (110) and each of its neighboring second semiconductor layers (120).

7. The semiconductor device of one of the preceding claims, further comprising a third semiconductor layer (130) adjoining the layer stack (110, 120) and each of the first semiconductor region (15), and the at least one second semiconductor region (14), wherein the third semiconductor layer (130) comprises a first region (131) arranged between the first semiconductor region (15) and the at least one second semiconductor region (14) in a first direction (x).

8. The semiconductor device of any of the preceding claims, further comprising a third semiconductor region (13) adjoining the plurality of first semiconductor layers (110), wherein
the first semiconductor region (15) is spaced apart from the third semiconductor region (13) in the first direction (x);
the at least one second semiconductor region (14) is arranged between the third semiconductor region (13) and the first semiconductor region (15), and is spaced apart from the third semiconductor region (13);
the first semiconductor device (M1) is a first transistor device; and
the first semiconductor region (15) forms a drain region of the first transistor device, the at least one second semiconductor region (14) forms at least one gate region of the transistor device, and the third semiconductor region (13) forms a source region of the first transistor device

9. The semiconductor device of any one of the preceding claims, further comprising a second transistor device (M2) that is at least partly integrated in a second section (132) of the third semiconductor layer (130), wherein the second section (132) is spaced apart from the first section (131).

10. The semiconductor device of claim 9, wherein the second transistor device (M2) comprises:
a second source region (21) of the first doping type;
a second drain region (23) of the first doping type spaced apart from the second source region (21);
a body region (22) of the second doping type adjoining the second source region (22) and arranged between the second source region (21) and the second drain region (23); and
a gate electrode (24) adjacent the body region (22) and dielectrically insulated from the body region (22) by a gate dielectric (25)

11. A method for producing a semiconductor device, the method comprising:
forming a layer stack with a plurality of first layers (110) of a first doping type, a plurality of second layers (120) of a second doping type complementary to the first doping type, and at least one barrier layer (40) that is configured to form a diffusion barrier, wherein each of the at least one barrier layer (40) is arranged in parallel to the first surface (101) and the second surface (102) and adjacent to one of the first semiconductor layers (110), or adjacent to one of the second semiconductor layers (120), or both;
forming a first semiconductor region (15) such that the first semiconductor region (15) adjoins the plurality of first semiconductor layers (110); and
forming at least one second semiconductor region (14) such that each of the at least one second semiconductor region (14) adjoins at least one of the plurality of second semiconductor layers (120), and is spaced apart from the first semiconductor region (15).

12. The method of claim 11, wherein forming the layer stack comprises
forming at least one epitaxial layer (140) by depositing a layer of semiconductor material; and
implanting ions into at least one of the epitaxial layers (140) to form the at least one barrier layer (40).

13. The method of claim 11, wherein forming the layer stack comprises
forming at least one epitaxial sub-layer (140₁) by depositing a layer of semiconductor material; and
forming a barrier layer (40) on or below each of the at least one epitaxial sub-layer (140₁) by depositing a layer of semiconductor or non-semiconductor material.

14. The method of any of claims 11 to 13, wherein forming the layer stack further comprises
forming at least two first implantation regions (111) of one of a first type or a second type at different vertical positions of the at least one epitaxial layer (140); and
forming at least one second implantation region (121) of a type that is complementary to the type of the first implantation regions, wherein the first implantation regions (111) and the second implantation regions (121) are arranged alternatingly.

15. The method of claim 14, further comprising heating the at least one epitaxial layer (140) with the implantation regions (111, 121) formed therein, thereby diffusing the implanted ions and forming the first and second layers (110, 120).
